# EUROPEAN PATENT SPECIFICATION

(11) **EP 0 364 186 B1**
(45) Date of publication and mention of the grant of the patent: **16.02.1994**
(21) Application number: 89310291.3
(22) Date of filing: 09.10.1989
(51) Int. Cl.: G11C 11/409, H01L 23/528, H01L 27/108

(54) **Quasi-folded bitline**
Quasi-gefaltete Bitleitung
Ligne de bit quasi-pliée

(30) Priority: 12.10.1988 US 256670
(43) Date of publication of application: 18.04.1990
(73) Proprietor: TEXAS INSTRUMENTS INCORPORATED, Dallas Texas 75265 (US)
(72) Inventor: Rountree, Robert N., Richmond Texas 77469 (US)
(74) Representative: Abbott, David John

(56) References cited:
- IBM TECHNICAL DISCLOSURE BULLETIN, vol. 30, no. 11, April 1988, pages 246-248, Armonk, New York, US; "Double-traversing pseudo-folded-bitline design for cross-point memory cells"
- IBM TECHNICAL DISCLOSURE BULLETIN, vol. 24, no. 9, February 1982, pages 4800-4801, Armonk, New York, US; L. ARZUBI: "Folded bit line connection to sense latch"

## Description

### FIELD OF THE INVENTION

The present application is related to the field of high density memory design. More specifically, the present invention relates to lay-out schemes and interconnection schemes for memory arrays.

### BACKGROUND OF THE INVENTION

Organization of an array of memory cells is one of the keys to the density and electrical characteristic of the memory array. Organizational considerations are particularly acute in the area of dynamic Random Access Memories (dRAMs). DRAMS are generally comprised of memory cells which include a storage capacitor and a pass transistor controlling flow into and out of one plate of the storage capacitor. Because of the simple structure of the memory cells, high density of the memory array can be achieved. Memory cells are generally arrayed in an X Y grid with the gates of the pass transistors connected along the X-axis (commonly called the row direction), and the source of the pass transistor is connected to bitline in the Y direction (commonly called the column direction). In lower density memory arrays, the sense amplifier, which receives the data output from the column lines, received the cell signal on a single lead with the sense amplifier comparing the signal on that lead to a reference potential. As memory arrays grew denser and denser, the size of the capacitor in the memory cells grew smaller. Therefore, the signal provided when the capacitor is accessed also grew smaller. As the signal received grew smaller the ambient noise received on the line began to overwhelm the signal received from the capacitor. Therefore, more sophisticated sense amplification techniques were developed. An example of a memory layout and sense amplification technique can be found in Harland, U.S. Patent No. 4,045,783, issued August 30, 1977. The technique shown in Harland provides a balanced input to the sense amplifier. Noise signals caused by electrical fields are generated on both of the complementary bitlines. The sense amplifier provides compares the signal provided on the memory cell verses the signal provided on the balancing bitline. Thus, noise generated on both bitlines (common mode noise) is canceled. However, because balanced bitlines must run parallel to each other, only one memory cell on one of the parallel bitlines may be addressed. When memory cells were larger, the extra space consumed by the pair of bitlines was used by interleaved memory cells. Thus this space disadvantage was not a problem. Modern dRAM memory cell techniques have advanced to the point to where the surface area consumed by a memory cell is nearly as small as the surface area consumed by the bitline running to the memory cell. An example of such a memory cell is found in U.S. Patent Application Serial No. 122,560, (= US-A-4,797,373) which is under a notice of allowance and is assigned to the assignee of this application. With a cell occupying a minimum surface area, the area where a word line passes through a portion of a balanced pair of bitlines where it can not be connected to a memory cell to simply wasted space.

One solution to this problem is an open bitline technique. In this technique one of a pair of balanced bitlines extends on one side of sense amplifier while the other balanced bitline extends into the other side of the sense amplifier. The bitlines on opposite sides of the sense amplifier are interleaved with bitlines from sense amplifiers on the opposite sides of their respective arrays, thereby allowing addressing a memory cell at each crossing of a word line and bitline. Thus providing a "cross-point array". However, because the bitlines do not run near each other electrically. (i.e. parallel), noise generated on one bitline will not be present on the complementary bitline. Thus the signal to noise ratio of the signal stored on the memory cell versus the noise present on the bitlines is much higher than that with the the folded bitline concept.

### SUMMARY OF THE INVENTION

The problem is solved as indicated in claim 1.

The described embodiments of the present invention provide a memory array layout using complementary bitlines connected to a single sense amplifier. Extending from the sense amplifier, bitlines which are unconnected to memory cells are extended to the middle of the array. One complementary bitline is then connected to a series of memory cells extending away from the sense amplifier. The other complementary bitline loops back and is connected to a set of memory cells extending back towards the sense amplifier. The first extension from the sense amplifier may be advantageously formed in a metal layer above the substrate thereby occupying no space in the substrate itself. All noise generated on the first section of the bitlines will be canceled by the complementary parallel structure of the bitlines. Because the second section of the bitlines are laterally separated, a wordline passing across each of the second sections addresses a single memory cell. Therefore an optimally compact cross-point memory array may be fabricated. Using the described techniques an optimally compact array having improved signal to noise characteristics may be fabricated.

### BRIEF DESCRIPTION OF DRAWINGS

The invention is best understood with regard to the embodiment described in the following Detailed Description of the Preferred Embodiment in conjunction with the drawings wherein:
Figure 1 is a schematic drawing showing a prior art folded bitline layout;
Figure 2 is a schematic diagram showing a prior art open complementary bitline layout;
Figure 3 is a schematic drawing of one embodiment of the present invention;
Figure 4 is a plan view of the bitline portion of the embodiment shown in Fig. 3;
Figure 5 is a section view of section AA of Fig. 4.

### DETAILED DESCRIPTION OF THE PREFERRED EMBODIMENTS

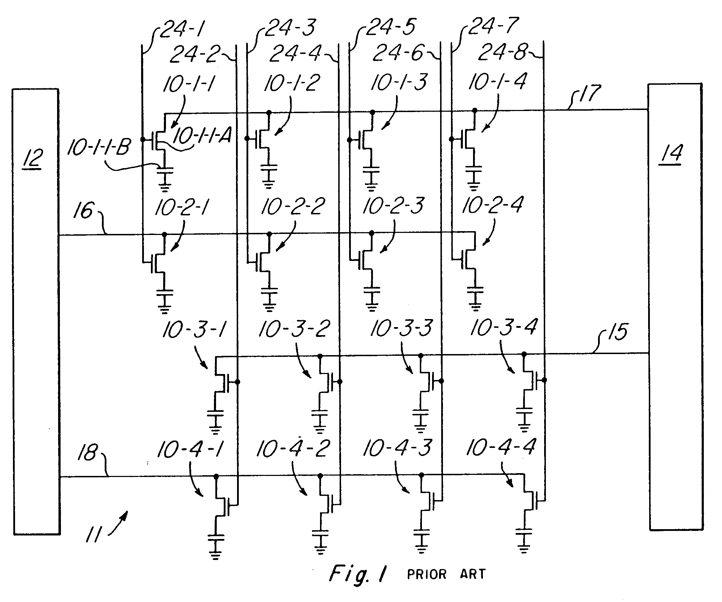

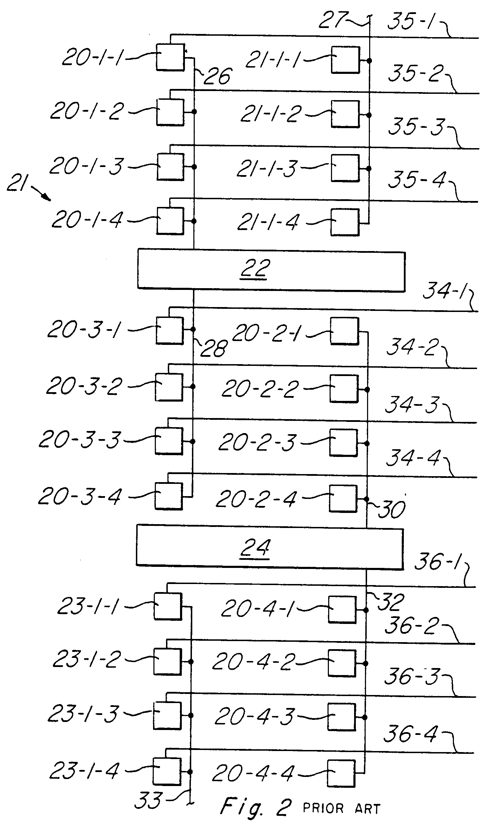

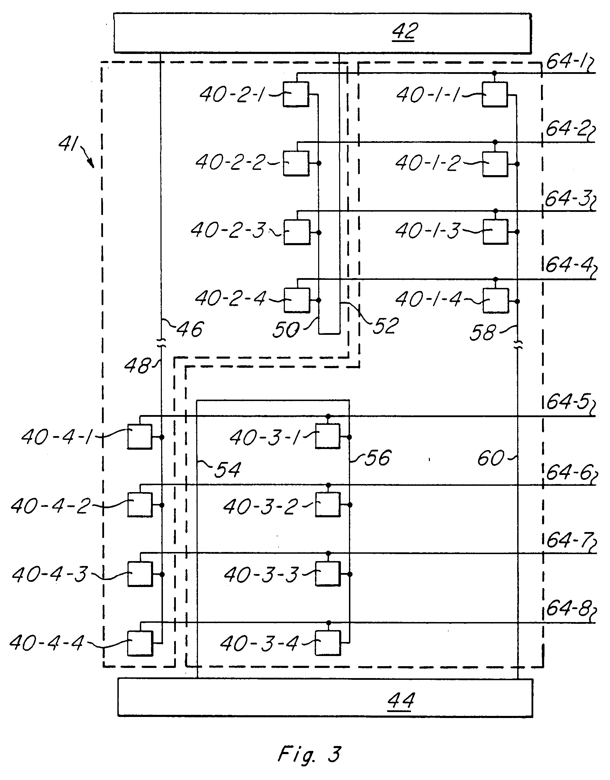

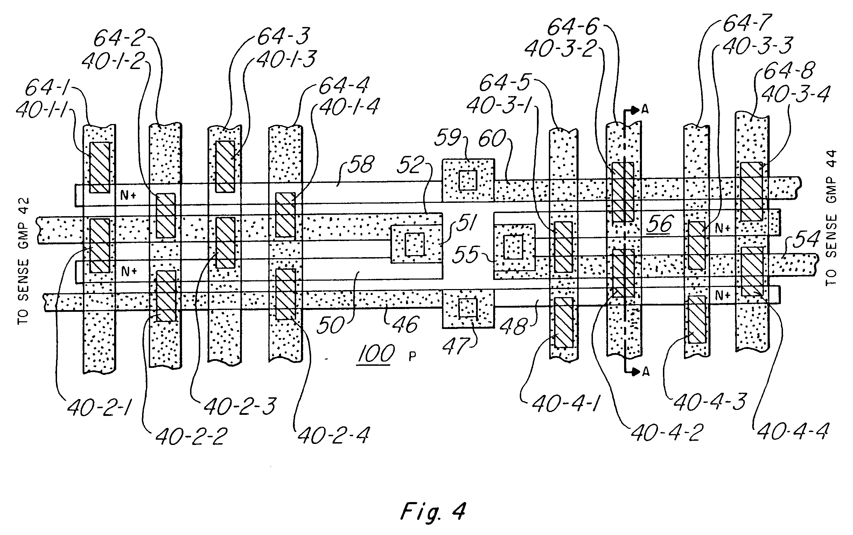

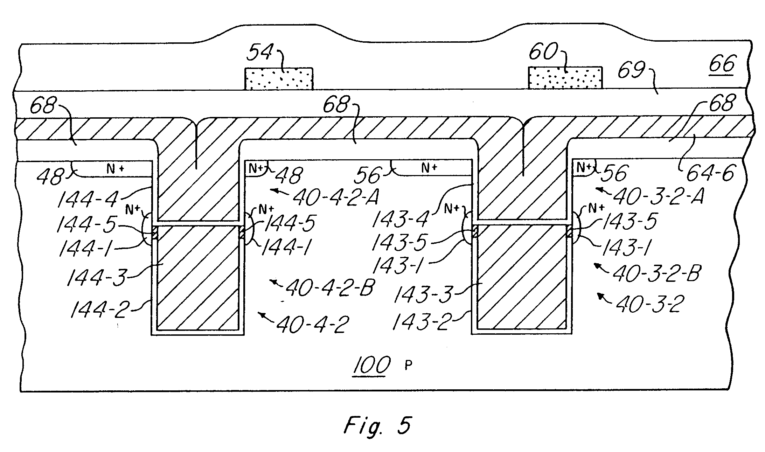

The embodiments described herein of the present invention are best described in comparison with prior art layout arrangements. Figure 1 is a schematic diagram showing a prior art memory array lay-out having two sense amplifiers with a folded bitline lay-out. Figure 2 is a schematic diagram showing two sense amplifiers having an open bitline layout. Figure 3 is a schematic diagram showing one embodiment of the present invention. Figure 4 further describes the embodiment shown in Fig. 3 by showing the plan view of the bitlines themselves. Figure 5 is a cross-section view of a portion of Fig. 4 showing the structure of the memory cells and the relative positions of the memory cell interconnections.

Memory array 11 of Fig. 1 illustrates the folded bitline concept which is known in the prior art. The array shown in Fig. 1 is a four-by-four, sixteen cell memory array. Memory cells 10-1-1 through 10-4-4 comprise the array. Each memory cell comprises a transistor and a capacitor. The transistor and capacitor of memory cell 10-1-1 are numbered indicating transistor 10-1-1-A and capacitor 10-1-1-B. Each memory cell of the array comprises a transistor and a capacitor although the numerical designations of the transistor and the capacitor within the memory cell are omitted. The data stored in memory cell 10-1-1 through 10-4-4 are read by sense amplifiers 12 and 14. Sense amplifier 12 reads from memory cells connected to bitlines 16 or 18. When sense amplifier 12 reads data provided on bitline 16, bitline 18 is provided to balance the load, voltage level and background noise levels of bitline 16. The difference between the signal provided on bitline 18 and the signal provided on bitline 16 is the signal provided by the addressed memory cell attached to bitline 16, as near as possible. Other techniques such as the inclusion of dummy memory cells (not shown) may be used to provide further balancing of bitlines 16 and 18. Sense amplifier 14 reads data provided on bitlines 15 and 17. Specific memory cells on bitlines 15, 16, 17, and 18 are selected by signals provided on wordlines 24-1 through 24-8. For example, if a logical high (high voltage) signal is provided on wordline 24-5, the data stored on memory cell 10-1-3 is provided to sense amplifier 14 via bitline 17 and the data provided in memory cell 10-2-3 is provided on bitline 16 to sense amplifier 12. Only one data bit at a time may be provided to a sense amplifier, thus separate wordlines are required for the memory cells on bitlines 15 and 18. Of importance, to address an array having four rows, eight wordlines (wordlines 24-1 through 24-8) must be provided. Thus the room required for the routing of eight word lines through the area must be provided. With optimal dense memory cells occupying an area slightly more than the width of a wordline, this arrangement precludes optimal density of the array.

Figure 2 is a schematic diagram illustrating a prior art memory array 21 using the open bitline architecture. Memory cells 20-1-1 through 20-4-4 correspond to memory cells 10-1-1 through 10-4-4 of array 11 of Fig. 1. Memory cells 21-1-1 through 21-1-4 and memory cells 23-1-1 through 23-1-4 are included to show the interwoven nature of further arrays extending to the left of the page and to the right of the page of Fig. 2. Each of the memory cells 20-1-1 through 20-4-4, 21-1-1 through 21-1-4 and 23-1-1 and 23-1-4 comprise a pass transistor and capacitor connected in a similar manner to those of memory cell 10-1-1 of Fig. 1. These memory cells are shown in Fig. 2 as boxes for simplicity. Sense amplifier 22 addresses memory cells connected to bitlines 26 and 28. Sense amplifier 24 addresses memory cells connected to bitlines 30 and 32. Wordlines 34-1 through 34-4 address memory cells 20-2-1 through 20-2-4 and 20-3-1 through 20-3-4. Wordlines 35-1 through 35-4 address memory cells 21-1-1 through 21-4 and 20-1-1 through 20-1-4. Wordlines 36-1 through 36-4 address memory cells 20-4-1 through 20-4-4 and 23-1-1 through 23-1-4. As an example, when a logical one (high voltage signal) is provided on wordline 34-2, the pass transistors (not shown) of memory cells 20-2-2 and 20-3-2 are turned on thus providing the data stored in memory cell 20-2-2 on bitline 30 and the data stored in memory cell 20-3-2 on bitline 28. In this example all of wordlines 35-1 through 35-4 and wordlines 36-1 through 36-4 must have a logical zero (low voltage signal) because only one bit of data may be provided to each of sense amplifiers 22 and 24. Bitline 26 serves as a complementary bitline to bitline 28 for sense amplifier 22 and bitline 32 serves as a complementary bitline to bitline 30 for sense amplifier 24. The array layout of array 21 provides superior packing density to the array layout of Fig. 1 because each wordline is connected to a memory cell at the intersection of each bitline. However, because balanced bitlines are formed on either side of the sense amplifiers, noise signals which occur onto one complementary bitline may not occur in a bitline on the opposite side of the sense amplifier. Thus noncommon mode noise can occur. Thus the signal of the memory cell which is addressed must be high enough to override the noncommon mode noise. In very dense memory cells, this is undesirable because the capacitance of the storage capacitor in the memory cell is limited by the size of the memory cell. Therefore, the signal provided by the memory cell is also limited.

Array 41 of Fig. 3 is a schematic diagram of one embodiment of the present invention. Although specific embodiments of the present invention herein described are not to be construed as limiting the scope of the invention. For example, the embodiment of Fig. 3 provides an array of dynamic Random Access Memory cells. Other types of arrays such as static Random Access Memories, programmable logical arrays and the like may benefit from the techniques taught in this specification and are considered within the scope of the invention. Memory array 41 includes memory cells 40-1-1 through 40-4-4. Memory cells 40-1-1 through 40-1-4 are connected to sense amplifier 44 by composite bitlines 58 and 60. Memory cells 40-2-1 through 40-2-4 are connected to sense amplifier 42 through composite bitlines 50 and 52. Memory cells 40-3-1 through 40-3-4 are connected to sense amplifier 44 by a composite bitline 54 and 56. Memory cells 40-4-1 through 40-4-4 are connected to sense amplifier 42 by composite bitline 46 and 48. Wordlines 64-1 through 64-4 address memory cells 40-1-1 through 40-2-4. Wordlines 64-5 through 64-8 address memory cells 40-3-1 through 40-4-4. Of significance, wordlines 64-1 through 64-8 address a memory cell connected to each of the four composite bitlines (46-48, 50-52, 54-56, and 58-60). Also of significance partial bitlines 46, 52, 54 and 60 serve only to connect other partial bitlines with their respective sense amplifiers. Because these partial bitlines need not be connected to the sources of the pass transistors of memory cells 40-1-1 through 40-4-4, these partial bitlines may be placed in a level of metal interconnect above the substrate without interfering with the memory cells below. Also of importance is that these bitlines are parallel to the other partial bitlines connected to the same sense amplifier. For example, partial bitlines 46 and 52 are connected to sense amplifier 42. Therefore, the noise generated in these partial bitlines is common mode and does not affect the sense operation of sense amplifier 42. A similar principal provides a common mode noise cancellation between the partial bitlines 54 and 60. In sum, array 41 provides common mode cancellation of some noise along with the high density of a cross-point array.

Figure 4 is a plan view of the array 41 of Fig. 3 excepting sense amplifiers 42 and 44. Sense amplifiers 42 and 44 have been omitted to provide clarity to the drawing. Wordlines 64-1 through 64-8 are formed in a polycrystalline silicon layer on an insulating layer (68 in Figure 5) above the substrate 100. Partial bitline 46, partial bitline 54, partial bitline 52 and partial bitline 60 are polycrystalline silicon formed on an insulating layer (69) in Fig. 5 above wordlines 64-1 through 64-8. All of the polycrystalline silicon conductors are formed using standard deposition, doping and lithograph techniques. Partial bitline 48, partial bitline 50, partial bitline 56 and partial bitline 58 are in N+ diffusions formed in the surface of the substrate by implantation and drive-in techniques known in the art. Partial bitline 46 is connected to partial bitline 48 through via 47. Partial bitline 50 is connected to partial bitline 52 through via 51. Partial bitline 54 is connected to partial bitline 56 through via 55. Partial bitline 58 is connected to partial bitline 60 through via 59. In another embodiment, partial bitlines 46, 52, 54 and 60 may be positioned directly above partial bit lines 50, 58, 48 and 56, respectively. This provides a true cross point array and a very compact layout.

Figure 5 is a cross-section diagram section AA of Fig. 4. Memory cells 40-4-2 and 40-3-2 are fabricated using the techniques shown in application Serial No. 122,560 (under notice of allowance) which is assigned to the assignee of the present application. Memory cell 40-3-2 operates as follows. Memory cell 40-3-2 comprises transistor 40-3-2-A and storage capacitor 40-2-3-B. Storage capacitor 40-3-2-B comprises polycrystalline silicon plug 143-3, dilelectric 143-2 and substrate 100. Transistor 40-3-2-A comprises partial bitline/drain 56, source 143-1, gate dilelectric 143-4 and a gate provided by polycrystalline silicon wordline 64-6. When a logical one (high voltage) signal is provided on wordline 64-6, a channel region is established between partial bitline 56 and source 143-1. The data that is either provided on bitline 56 or stored on polycrystalline silicon plug 143-4 is conducted through polycrystalline silicon plug 143-5 and the channel region formed between source region 143-1 and partial bitline 56. Memory cell 40-4-2 operates in a similar manner and components which are numbered in a parallel fashion correspond to the components described with regard to memory cell 40-3-2. Wordline 64-6 is insulated from substrate 100 by silicon dioxide region 68 which is either deposited or thermally formed on the surface of substrate 100. Partial bitlines 54 and 60 are separated from wordline 64-6 by insulator 68. Insulator 68 may be any number of suitable insulators known in the art, for example, silicon dioxide deposited by chemical vapor deposition. Insulating layer 66 is formed over the surface of partial bitlines 54 and 60 by, for example, chemical vapor deposition of silicon dioxide or other suitable insulator.

Although specific embodiments of the present invention are disclosed herein, they are not to be construed as limiting the scope of the invention. The present invention is limited only by the scope of the claims appended hereto wherein I claim:

## Claims

1. A memory array, comprising:
a first sense amplifier (42) having first and second input terminals;
a second sense amplifier (44) having first and second input terminals;
a first column of memory cells disposed between said first and second sense amplifiers, said first column including a first subset of memory cells (40-2), said first subset being a contiguous group of memory cells nearest said first sense amplifier (42), said first column also having a second subset (40-4), said second subset being those memory cells of said first column not included in said first subset;
a second column of memory cells disposed between said first and second sense amplifiers, said second column including a first subset of memory cells (40-1), said first subset being a contiguous group of memory cells nearest said first sense amplifier (42) and said first subset having the same number of memory cells as said first subset of said first column, said second column also including a second subset (40-3) consisting of those memory cells of said second column not in said first subset and said second subset having the same number of memory cells as said second subset of said first column;
a plurality of row lines (64), said row lines comprising conductors connected to the control terminal of no more than one memory cell in each of said first and second columns;
a first partial bitline (46) comprising a conductive line disposed parallel to said first subset (40-2) of said first column having the end of said first partial bitline nearest to said first sense amplifier (42) electrically connected to said first input terminal of said first sense amplifier;
a second partial bitline (48) comprising a conductive line disposed parallel to said second subset (40-4) of said first column electrically connected to each of said memory cells of said second subset of said first column and having the end of said second partial bitline nearest to said first sense amplifier connected to the end of said first partial bitline disposed away from said first sense amplifier;
a third partial bitline (52) comprising a conductive line disposed parallel to said first subset (40-2) of said first column having the end of said bitline nearest to said first sense amplifier (42) connected to said second input terminal of said first sense amplifier; and
a fourth partial bitline (50) comprising a conductive line disposed parallel to said first subset (40-2) of said first column electrically connected to each memory cell in said first subset of said first column, the end of said fourth partial bitline nearest to said second sense amplifier (44) being electrically connected to the end of said third partial bitline nearest said second sense amplifier.

2. A memory array as claimed in claim 1 wherein said first and third partial bitlines comprise deposited metal formed on an insulating layer, said insulating layer electrically separating said first and third partial bitlines and said second and fourth partial bitlines.

3. A memory array as claimed in claim 1 and wherein said first and third partial bitlines are formed of polysilicon.

4. A memory array as claimed in claim 1, claim 2 or claim 3 and wherein said second and fourth partial bitlines comprise highly doped regions in a semiconductive substrate.

5. A memory array as claimed in any preceding claim and wherein said first partial bitline is positioned vertically aligned with said second partial bitline and said third partial bitline is positioned vertically aligned with said fourth partial bitline.

6. A memory array as claimed in any preceding claim and wherein each cell includes a storage capacitor and a pass transistor.

7. A device including a memory array as claimed in any preceding claim.

8. A device as claimed in claim 7 and wherein said memory array is a dynamic random access memory.

## Patentansprüche

1. Speichermatrix, enthaltend:
einen ersten Leseverstärker (42) mit einem ersten und einem zweiten Eingangsanschluß;
einen zweiten Leseverstärker (44) mit einem ersten und einem zweiten Eingangsanschluß;
eine erste Spalte von Speicherzellen, die zwischen dem ersten und dem zweiten Leseverstärker angeordnet sind, wobei die erste Spalte eine erste Teilmenge von Speicherzellen (40-2) umfaßt, wobei die erste Teilmenge eine zusammenhängende Gruppe von dem ersten Leseverstärker (42) am nächsten liegenden Speicherzellen ist, die erste Spalte auch eine zweite Teilmenge (40-4) aufweist und die zweite Teilmenge aus denjenigen Speicherzellen der ersten Spalte besteht, die nicht in der ersten Teilmenge enthalten sind;
eine zweite Spalte von Speicherzellen, die zwischen dem ersten und dem zweiten Leseverstärker angeordnet sind, wobei die zweite Spalte eine erste Teilmenge von Speicherzellen (40-1) umfaßt, die erste Teilmenge eine zusammenhängende Gruppe von dem ersten Leseverstärker (42) am nächsten liegenden Speicherzellen ist und die erste Teilmenge die gleiche Anzahl von Speicherzellen wie die erste Teilmenge der ersten Spalte aufweist, wobei die zweite Spalte auch eine zweite Teilmenge (40-3) aufweist, die aus denjenigen Speicherzellen der zweiten Spalte besteht, die nicht in der ersten Teilmenge sind, und die zweite Teilmenge die gleiche Anzahl von Speicherzellen wie die zweite Teilmenge der ersten Spalte aufweist;
eine Anzahl von Zeilenleitungen (64), wobei die Zeilenleitungen Leiter aufweisen, die mit dem Steueranschluß von nicht mehr als einer Speicherzelle in jeder der ersten und der zweite Spalten verbunden sind;
eine erste Teilbitleitung (46) mit einer leitfähigen Leitung, die parallel zu der ersten Teilmenge (40-2) der ersten Spalte angeordnet ist, wobei das dem ersten Leseverstärker (42) am nächsten gelegene Ende der ersten Teilbitleitung elektrisch mit dem ersten Eingangsanschluß des ersten Leseverstärkers verbunden ist;
eine zweite Teilbitleitung (48) mit einer leitfähigen Leitung, die parallel zu der zweiten Teilmenge (40-4) der ersten Spalte angeordnet und elektrisch mit jeder der Speicherzellen der zweiten Teilmenge der ersten Spalte verbunden ist, wobei das dem ersten Leseverstärker am nächsten liegende Ende der zweiten Teilbitleitung mit dem Ende der ersten Teilbitleitung verbunden ist, das von dem ersten Leseverstärker entfernt angeordnet ist;
eine dritte Teilbitleitung (52) mit einer leitfähigen Leitung, die parallel zu der ersten Teilmenge (40-2) der ersten Spalte angeordnet ist, wobei das dem ersten Leseverstärker (42) am nächsten liegende Ende dieser Bitleitung mit dem zweiten Eingangsanschluß des ersten Leseverstärkers verbunden ist, sowie
eine vierte Teilbitleitung (50) mit einer leitfähigen Leitung, die parallel zu der ersten Teilmenge (40-2) der ersten Spalte angeordnet und mit jeder Speicherzelle in der ersten Spalte elektrisch verbunden ist, wobei das dem zweiten Leseverstärker (44) am nächsten liegende Ende der vierten Teilbitleitung mit dem dem zweiten Leseverstärker am nächsten liegenden Ende der dritten Teilbitleitung elektrisch verbunden ist.

2. Speichermatrix nach Anspruch 1, bei der die erste und die dritte Teilbitleitung auf einer Isolierschicht gebildetes, abgeschiedenes Metall aufweisen, wobei die Isolierschicht die erste und die dritte Teilbitleitung und die zweite und die vierte Teilbitleitung elektrisch trennt.

3. Speichermatrix nach Anspruch 1, bei der die erste und die dritte Teilbitleitung aus Polysilicium gebildet sind.

4. Speichermatrix nach Anspruch 1, Anspruch 2 oder Anspruch 3, bei der die zweite und die vierte Teilbitleitung hoch dotierte Zonen in einem Halbleitersubstrat aufweisen.

5. Speichermatrix nach einem der vorhergehenden Ansprüche, bei der die erste Teilbitleitung mit der zweiten Teilbitleitung vertikal ausgerichtet positioniert ist und die dritte Teilbitleitung mit der vierten Teilbitleitung vertikal ausgerichtet positioniert ist.

6. Speichermatrix nach einem der vorhergehenden Ansprüche, bei der jede Zelle einen Speicherkondensator und einen Durchgangstransistor aufweist.

7. Vorrichtung, die eine Speichermatrix nach einem der vorhergehenden Ansprüche umfaßt.

8. Vorrichtung nach Anspruch 7, bei der die Speichermatrix ein dynamischer Speicher mit wahlfreiem Zugriff ist.

## Revendications

1. Réseau de mémoire, comprenant :
- un premier amplificateur de détection (42) ayant une première et une deuxième bornes d'entrée ;
- un deuxième amplificateur de détection (44) ayant une première et une deuxième bornes d'entrée ;
- une première colonne de cellules de mémoire disposées entre lesdits premier et deuxième amplificateurs de détection, ladite première colonne comprenant un premier sous-ensemble de cellules de mémoire (40-2), ledit premier sous-ensemble étant un groupe contigu de cellules de mémoire le plus proche dudit premier amplificateur de détection (42), ladite première colonne ayant aussi un deuxième sous-ensemble (40-4), ledit deuxième sous-ensemble comprenant celles des cellules de mémoire de ladite première colonne non comprises dans ledit premier sous-ensemble ;
- une deuxième colonne de cellules de mémoire disposées entre lesdits premier et deuxième amplificateurs de détection, ladite deuxième colonne comprenant un premier sous-ensemble de cellules de mémoire (40-1), ledit premier sous-ensemble étant un groupe contigu de cellules de mémoire les plus proches dudit premier amplificateur de détection (42) et ledit premier sous-ensemble ayant le même nombre de cellules de mémoire que ledit premier sous-ensemble de ladite première colonne, ladite deuxième colonne comprenant aussi un deuxième sous-ensemble (40-3) constitué de celles des cellules de mémoire de ladite deuxième colonne non comprises dans ledit premier sous-ensemble et ledit deuxième sous-ensemble ayant le même nombre de cellules de mémoire que ledit deuxième sous-ensemble de ladite première colonne ;
- une pluralité de lignes de rangée (64), chaque ligne de rangée comprenant des conducteurs reliés à la borne de commande d'au plus une cellule de mémoire dans chacune desdites première et deuxième colonnes ;
- une première ligne partielle de bits (46) comprenant une ligne conductrice disposée parallèlement audit premier sous-ensemble (40-2) de ladite première colonne, ayant l'extrémité de ladite première ligne partielle de bits la plus proche dudit premier amplificateur de détection (42) relié électriquement à ladite première borne d'entrée dudit premier amplificateur de détection ;
- une deuxième ligne partielle de bits (48) comprenant une ligne conductrice disposée parallèlement audit deuxième sous-ensemble (40-4) de ladite première colonne et reliée électriquement à chacune desdites cellules de mémoire dudit deuxième sous-ensemble de ladite première colonne, et ayant l'extrémité de ladite deuxième ligne partielle de bits la plus proche dudit premier amplificateur de détection (42) reliée à l'extrémité de ladite première ligne partielle de bits éloignée dudit premier amplificateur de détection ;
- une troisième ligne partielle de bits (52) comprenant une ligne conductrice disposée parallèlement audit premier sous-ensemble (40-2) de ladite première colonne, ayant l'extrémité de ladite ligne de bits la plus proche dudit premier amplificateur de détection (42) reliée électriquement à ladite deuxième borne d'entrée dudit premier amplificateur de détection ; et
- une quatrième ligne partielle de bits (50) comprenant une ligne conductrice disposée parallèlement audit premier sous-ensemble (40-2) de ladite première colonne, reliée électriquement à chaque cellule de mémoire dans ledit premier sous-ensemble de ladite première colonne, l'extrémité de ladite quatrième ligne partielle de bits la plus proche dudit deuxième amplificateur de détection (44) étant reliée électriquement à l'extrémité de ladite troisième ligne partielle de bits la plus proche dudit deuxième amplificateur de détection.

2. Réseau de mémoire selon la revendication 1, dans lequel lesdites première et troisième lignes partielles de bits comprennent du métal déposé formé sur une couche isolante, ladite couche isolante séparant électriquement lesdites première et troisième lignes partielles de bits et lesdites deuxième et troisième lignes partielles de bits.

3. Réseau de mémoire selon la revendication 1, dans lequel lesdites première et troisième lignes partielles de bits sont formées de polysilicium.

4. Dispositif selon la revendication 1, 2 ou 3, dans lequel lesdites deuxième et quatrième lignes partielles de bits comprennent des régions à dopage élevé dans un substrat semi-conducteur.

5. Réseau de mémoire selon l'une quelconque des revendications précédentes, dans lequel ladite première ligne partielle de bits est positionnée en alignement vertical avec ladite deuxième ligne partielle de bits et ladite troisième ligne partielle de bits est positionnée en alignement vertical avec ladite quatrième ligne partielle de bits.

6. Réseau de mémoire selon l'une quelconque des revendications précédentes, dans lequel chaque cellule comprend un condensateur de stockage et un transistor ballast.

7. Dispositif comprenant un réseau de mémoire selon l'une quelconque des revendications précédentes.

8. Dispositif selon la revendication 7, dans lequel ledit réseau de mémoire est une mémoire dynamique à accès direct.
